(19) Europäisches Patentamt
European Patent Office
Office européen des brevets

(11) **EP 1 937 041 B1**

(12) **EUROPEAN PATENT SPECIFICATION**

(45) Date of publication and mention
of the grant of the patent:
**25.05.2011 Bulletin 2011/21**

(51) Int Cl.:
*H05K 1/02* *(2006.01)*          *H05K 1/18* *(2006.01)*

(21) Application number: **07123640.0**

(22) Date of filing: **19.12.2007**

(54) **Printed circuit board, light emitting apparatus having the same and manufacturing method thereof**

Leiterplatte, lichtemittierende Vorrichtung damit und Verfahren zu ihrer Herstellung

Carte de circuit imprimé, appareil électroluminescent en étant équipé et son procédé de fabrication

(84) Designated Contracting States:
**DE FR GB IT NL**

(30) Priority: **21.12.2006 KR 20060131740**

(43) Date of publication of application:
**25.06.2008 Bulletin 2008/26**

(73) Proprietors:
• **LG Electronics Inc.**
**Yeongdeungpo-gu**
**Seoul 150-721 (KR)**
• **LG Innotek Co., Ltd.**
**Seoul 100-714 (KR)**

(72) Inventors:
• **Kim, Yong Suk**
**Seocho-gu, 137-724, Seoul (KR)**
• **Seo, Bu Wan**
**Seocho-gu, 137-724, Seoul (KR)**
• **Hur, Hoon**
**Seocho-gu, 137-724, Seoul (KR)**

(74) Representative: **Cabinet Plasseraud**
**52, rue de la Victoire**
**75440 Paris Cedex 09 (FR)**

(56) References cited:
**WO-A-2007/002644     US-A- 4 835 598**

**Description**

**BACKGROUND OF THE INVENTION**

**Field of the Invention**

The present invention relates to a printed circuit board, a light emitting apparatus having the same and a manufacturing method thereof, and more particularly to a printed circuit board capable of improving reliability, a light emitting apparatus having the same and a manufacturing method thereof.

**Discussion of the Related Art**

A light emitting diode (hereinafter, referred to as "LED") is a device which realizes light emission based on a field effect by depositing a compound semiconductor thin film on a substrate. Recently, the LED is widely used as a display unit of various electronic appliances for lighting, communication and the like.

Among various application fields of LED, a lighting field has been actively researched to replace a back light unit (BLU) used in a thin LCD TV and a fluorescence lamp. Further, the structure, material and package of LED have been vigorously researched to apply the LED to the application fields.

The LED is operated by injecting electrons and holes and emitting energy generated in combination of the electrons and holes in the form of light. In this case, some energy is emitted in the form of heat. The generated heat can be relieved by a proper heat sink in manufacturing a package.

However, as a high output LED having an LED chip size of 1 mm x 1 mm or more is developed, it is possible to achieve the LED brightness of 10 CD or more. By arranging several high output chips, it is possible to use various LED modules, for example, an electric signboard, a back light unit and a lighting module.

In such an application product, since a large number of LEDs are provided, the temperature of heat emitted from the LEDs is very high. Further, since the LED brightness is in proportion to the LED heat, it is necessary to solve a heat problem in an LED module such as a printed circuit board mounted with the LED. The document WO 2007/002644 describes a light emitting diode package for high temperature operation.

**SUMMARY OF THE INVENTION**

Accordingly, the present invention is directed to a printed circuit board, a light emitting apparatus having the same and a manufacturing method thereof that substantially obviate one or more problems due to limitations and disadvantages of the related art.

An object of the present invention is to provide a printed circuit board capable of efficiently emitting heat generated from a light emitting device, a light emitting apparatus having the printed circuit board and a manufacturing method thereof.

Additional advantages, objects, and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

To achieve these objects and other advantages and in accordance with the purpose of the invention, as embodied and broadly described herein, a light emitting apparatus according to claim 1 is provided.

In another aspect of the present invention, a manufacturing method of a light emitting apparatus according to claim 10 is provided.

It is to be understood that both the foregoing general description and the following detailed description of the present invention are exemplary and explanatory and are intended to provide further explanation of the invention as claimed.

**BRIEF DESCRIPTION OF THE DRAWINGS**

The accompanying drawings, which are included to provide a further understanding of the invention and are incorporated in and constitute a part of this application, illustrate embodiment(s) of the invention and together with the description serve to explain the principle of the invention. In the drawings:

FIG. 1 illustrates a cross-sectional view showing a first embodiment of the present invention;

FIG. 2 illustrates a cross-sectional view showing a printed circuit board according to a second embodiment of the present invention;

FIG. 3 illustrates a cross-sectional view showing a light emitting apparatus according to the second embodiment of the present invention; and

FIG. 4 illustrates a flowchart showing a manufacturing method of the light emitting apparatus according to the second embodiment of the present invention.

## DETAILED DESCRIPTION OF THE INVENTION

Reference will now be made in detail to the preferred embodiments of the present invention, examples of which are illustrated in the accompanying drawings. Wherever possible, the same reference numbers will be used throughout the drawings to refer to the same or like parts.

Hereinafter, embodiments of the present invention will be described in detail with reference to the accompanying drawings.

Since there can be a variety of permutations and embodiments of the present invention, certain embodiments will be illustrated and described with reference to the accompanying drawings. This, however, is by no means to restrict the present invention to certain embodiments, and shall be construed as including all permutations, equivalents and substitutes covered by the spirit and scope of the present invention.

It is to be understood that when an element such as a layer, an area or a substrate is described to exist "on" the other element, it may directly exist on the other element or an intermediate element may exist between them. It is to be understood that when a part of an element such as surface is expressed as "inner", it is further away from the outside of the device than other parts of the element.

Further, relative terms such as "beneath" or "overlies" will be used to describe the relation between one layer or area and the other layer or the relation between one layer of an area and the area with respect to a substrate or a reference layer as shown in the drawings.

It is to be understood that these terms are intended to cover another aspects of devices in addition to aspects depicted in the drawings. Finally, the term "directly" means that no element is interposed between devices. The term "and/or" includes one or more combinations of related lists, and all combinations.

Although the terms such as "first" and "second" are used to describe various elements, components, areas, layers and/or zones, it is to be understood that the elements, components, areas, layers and/or zones are not limited by those terms.

<first embodiment>

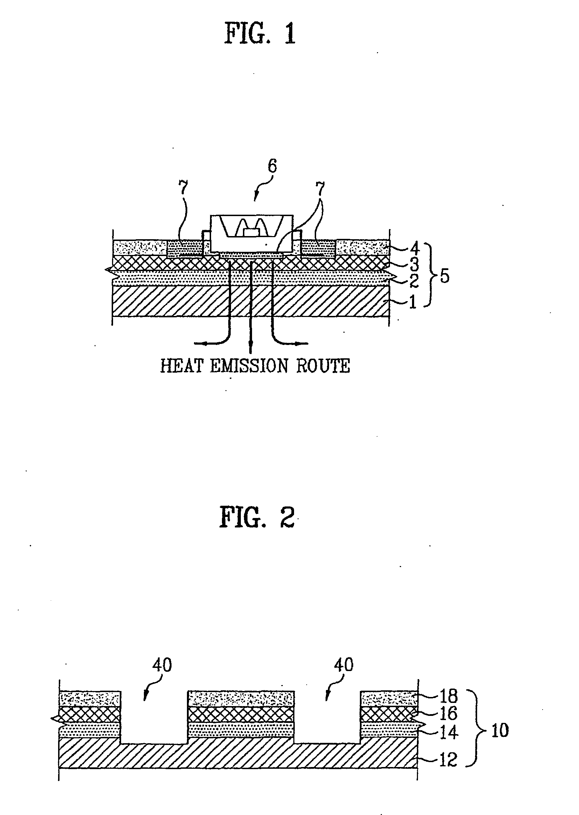

A first embodiment of the present invention will be described with reference to FIG. 1.

As shown in FIG. 1, a light emitting apparatus including a metal core printed circuit board may be formed by mounting a light emitting device package 6 on a printed circuit board 5.

The printed circuit board 5 of the light emitting apparatus may employ one of circuit boards having various shapes. However, a light emitting module using a high output light emitting device package may employ a metal core printed circuit board (MCPCB) in which a first metal layer 1, an insulating layer 2, a second metal layer 3 and a solder resist layer 4 are sequentially stacked.

As an example of the structure of the metal core printed circuit board, an aluminum layer is used as the first metal layer 1 and a copper layer is used as the second metal layer 3 on the aluminum layer to form a circuit. In order to electrically insulate the first metal layer 1 from the second metal layer 3, the insulating layer 2 formed of an insulating material such as epoxy may be positioned between the first metal layer 1 and the second metal layer 3.

The first metal layer 1 and the second metal layer 3 may be formed of various metals such as iron and silver as well as the above-mentioned aluminum and copper.

Further, the solder resist layer 4 is disposed on the second metal layer 3. In this case, the solder resist layer 4 is removed only at a portion to be coated with solder for combining the second metal layer 3 with parts.

The light emitting device package 6 mounted with a light emitting device chip is attached to the second metal layer 3 of the metal core printed circuit board by a solder 7 through the portion without the solder resist layer 4.

In the structure of the light emitting apparatus, heat generated from the light emitting device package 6 may be emitted into the air through the solder 7, the second metal layer 3, the insulating layer 2 and the first metal layer 1. In this case, since the emitted heat is in proportion to a heat radiation area and in inverse proportion to a distance, heat is transferred along a vertical moving route with respect to the light emitting device package.

Generally, as there are a larger number of the boundaries between materials, the thermal conductivity becomes lower. The heat is in proportion to a heat radiation area and in inverse proportion to a moving distance. In the above-described structure of the light emitting apparatus, since there are many routes of heat transfer, the moving distance becomes long.

Further, since a portion which is directly contacted to the light emitting device package 6 is the second metal layer 3 formed of copper, it may be difficult to smoothly emit heat to the first metal layer 1.

<second embodiment>

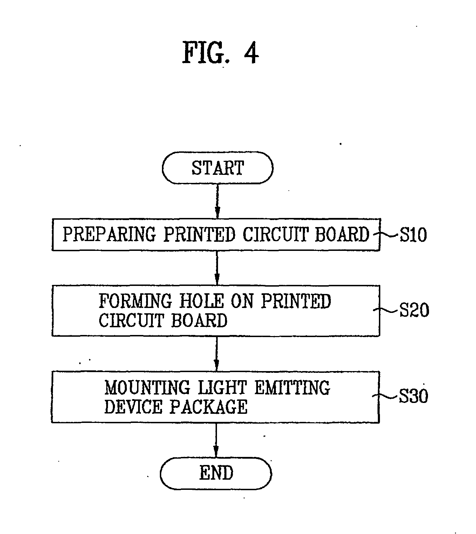

Hereinafter, a second embodiment of the present invention will be described with reference to FIGs. 2 to 4.

As shown in FIG. 2, a printed circuit board 10 according to the second embodiment is formed by sequentially stacking a first metal layer 12, an insulating layer 14, a second metal layer 16 and a solder resist layer 18. In this case, a mounting groove 40 for mounting a light emitting device package is formed on the printed circuit board 10 to have a depth reaching at least an upper surface of the first metal layer 12.

As shown in FIG. 2, the mounting groove 40 may be formed to be deeper than the upper surface of the first metal layer 12 by a specified depth. The mounting groove 40 may be formed to have substantially the same size as that of a light emitting device package to be mounted such that the light emitting device package can be closely contacted to the mounting groove 40.

That is, the mounting groove 40 may have different shapes and depths according to the type and size of the light emitting device package to be mounted.

In this case, an aluminum layer is used as the first metal layer 12 and the second metal layer 16 formed of copper is disposed on the aluminum layer to form a circuit. The insulating layer 14 formed of an insulating material such as epoxy is positioned between the first metal layer 12 and the second metal layer 16.

The first metal layer 12 and the second metal layer 16 may be formed of various metals such as iron and silver as well as the above-mentioned aluminum and copper.

The first metal layer 12 may have a thickness larger than that of the second metal layer 16 forming a circuit, which may vary according to a height of the light emitting device package to be mounted.

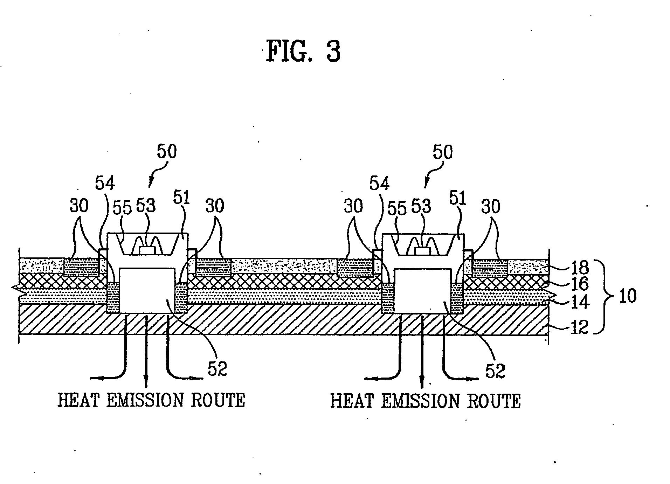

As shown in FIG. 3, a light emitting device package 50 is mounted on the mounting groove 40 of the printed circuit board 10.

The light emitting device package 50 includes a package body 51 with a mounting portion 55, a heat sink 52 attached to the lower side of the package body 51 and a light emitting device 53 mounted on the mounting portion 55. The mounting portion 55 may be formed in the shape of an inwardly recessed groove.

As shown in the drawings, the heat sink 52 is connected to the lower side of the package body 51 to form a heat transfer route. A lead 54 electrically connected to the light emitting device 53 is at the side of the package body 51.

The lead 54 is electrically connected to the second metal layer 16 through a solder 30 disposed at a portion from which the solder resist layer 18 has been removed.

Further, the solder 30 is also coated between the heat sink 52 of the light emitting device package 50 and the first metal layer 12 such that heat generated from the light emitting device 53 is efficiently conducted to the first metal layer 12.

That is, the solder 30 is positioned between the heat sink 52 and the first metal layer 12, thereby firmly fixing the light emitting device package 50 on the printed circuit board 10. Further, a contact area between the heat sink 52 and the first metal layer 12 may be enlarged through the solder 30.

As shown in FIG. 3, it is advantageous that the heat sink 52 has a height capable of reaching the first metal layer 12 when the light emitting device package 50 is installed on the printed circuit board 10. Accordingly, the heat sink 52 may have a shape protruded downward from the light emitting device package 50.

That is, with regard to the thickness of each layer of the printed circuit board 10 and the height of the light emitting device package 50, when the light emitting device package 50 is mounted on the mounting groove formed on the printed circuit board 10, the lead 54 may be positioned properly for soldering in a state where the heat sink 52 of the light emitting device package 50 is in contact with the first metal layer 12.

In this case, the solder 30 for mounting the light emitting device package 50 may be formed by coating cream solder and hardening the solder through a proper process such as a process of applying heat.

A heat emission route of a light emitting apparatus including the printed circuit board 10 and the light emitting device package 50 is described below.

As described above, the light emitting device package 50 is closely contacted to the first metal layer 12 through the heat sink 52. The heat generated from the light emitting device package 50 may be emitted through the closely contacted first metal layer 12.

In other words, the heat generated from the light emitting device package 50 is directly transferred to the first metal layer 12 of the printed circuit board 10. Accordingly, the moving distance of heat is largely reduced and it is effective for heat radiation.

Compared to the first embodiment, although heat is transferred through the solder 7, the second metal layer 3, the insulating layer 2 and the first metal layer 1 in the light emitting apparatus of the first embodiment, heat is transferred and emitted to the outside through only the first metal layer 12 in the light emitting apparatus including the printed circuit board 10 according to the second embodiment. Thus, the number of layers through which heat moves is reduced and the moving distance of heat is also reduced, thereby having an excellent heat radiation effect.

In order to promote the understanding of heat transfer in the present invention, a formula for thermal resistance $R_{th}$ is expressed in Eq. 1.

$$R_{th} = \frac{L}{kA} \qquad [°C/W] \qquad \dots\dots\dots\dots\dots\dots\dots\dots\dots Eq. 1$$

In Eq. 1, L refers to a thickness of a surface perpendicular to heat flow and k refers to thermal conductivity. Further, A refers to an area of the surface perpendicular to heat flow.

That is, it means that the heat radiation effect is more excellent as the thermal resistance is lower. In order to decrease the thermal resistance, the thickness L should be small and the area A should be large. Accordingly, the moving distance of heat, that is, the number of layers through which heat moves, should be reduced to enhance the heat radiation effect.

Thus, in the first embodiment or a general MCPCB, the thermal resistance is expressed by the following equation.

$$R_{th} = R_{2nd\ metal} + R_{insulating\ layer} + R_{1st\ metal}$$

However, the thermal resistance according to the second embodiment is expressed by the following equation.

$$R_{th} = R_{1st\ metal}$$

That is, in the second embodiment, since the thermal resistance is calculated exclusive of the resistance due to the second metal layer 16 and the resistance due to the insulating layer 14, it is possible to significantly improve heat transfer compared to the first embodiment or a general MCPCB.

Hereinafter, a method of manufacturing the light emitting apparatus according to the second embodiment will be described with reference to FIGs. 2 to 4.

First, there is prepared the printed circuit board 10 in which the first metal layer 12, the insulating layer 14, the second metal layer 16 and the solder resist layer 18 are sequentially stacked (S10). That is because it is advantageous to employ the metal core printed circuit board 10 including the above-described metal layers 12 and 16 in the light emitting device module using a high output light emitting device.

The solder resist layer 18 is a coating layer which coats the second metal layer 16. A different layer such as paint, a PSR layer and a polymer layer may be provided instead of the solder resist layer 18 to coat the second metal layer 16 forming circuit lines.

Then, the mounting groove 40 for the light emitting device package is formed on the printed circuit board 10 to have a depth reaching at least the upper surface of the first metal layer 12 (S20).

It is preferable to form the mounting groove 40 through a drilling process by a computer numerical control (CNC) method. Further, the mounting groove 40 may be formed to have different sizes by changing a drill size according to the size of the light emitting device package 50.

In the drilling process, a hole may be formed on the printed circuit board 10 by a computer numerical control method using X-Y coordinates based on the information of the mounting groove 40 requested for designing the printed circuit board 10.

Further, the depth of the mounting groove 40 is determined based on the information of the thickness of the heat sink 52 of the light emitting device package 50.

In other words, in order that heat generated from the light emitting device package 50 is transferred directly to the first metal layer 12, the depth of the mounting groove 40 is determined such that the heat sink 52 is closely contacted to the first metal layer 12.

Finally, the light emitting device package 50 is mounted on the printed circuit board 10 with the mounting groove 40 (S30). The mounting process is performed by coating cream solder on the heat sink 52 of the light emitting device package 50 and a portion of the second metal layer 16 corresponding to the lead 54 and hardening the solder through a hardening process, for example, heat hardening. Consequently, the heat sink 52 is coupled to the first metal layer 12 and the lead 54 is coupled to the second metal layer 16.

**Claims**

1.  A light emitting apparatus comprising:

    a printed circuit board (10) comprising:

        a first metal layer (12);
        an insulating layer (14) disposed on the first metal layer;
        a second metal layer (16) disposed on the insulating layer;
        a coating layer (18) disposed on the second metal layer; and
        a mounting groove (40) for mounting a light emitting device package (50);
        and

    the light emitting device package (50) comprising:

        a package body (51);
        a light emitting device (53) formed on the package body; and
        a lead (54) connected to the second metal layer,

    wherein the mounting groove (40) has a depth reaching at least an upper surface of the first metal layer (12).

2.  The light emitting apparatus according to claim 1, wherein the first metal layer (12) is any one of an aluminum layer and a copper layer, and the second metal layer (16) is a copper layer.

3.  The light emitting apparatus according to claim 1 or 2, wherein the light emitting device package (50) further comprises a heat sink (52) connected to the package body (51) to form a heat transfer route.

4.  The light emitting apparatus according to any one of claims 1 to 3, wherein the mounting groove (40) has substantially the same width as that of the light emitting device package (50).

5.  The light emitting apparatus according to any one of claims 1 to 4, wherein the first metal layer (12) has a thickness larger than that of the second metal layer (16).

6.  The light emitting apparatus according to any one of claims 3 to 5, wherein the light emitting device package (50) further comprises a solder (30) coated between the heat sink (52) and the first metal layer (12).

7.  The light emitting apparatus according to any one of claims 3 to 6, wherein the heat sink (52) is in contact with a lower side of the package body (51).

8.  The light emitting apparatus according to any one of claims 1 to 7, wherein the lead (54) is connected to the second metal layer (16) by a solder (30) in the coating layer (18) positioned on the second metal layer (16).

9.  The light emitting apparatus according to any one of claims 1 to 8, wherein the coating layer (18) is a solder resist.

10. A manufacturing method of a light emitting apparatus, comprising:

    preparing (S10) a printed circuit board (10) in which a first metal layer (12), an insulating layer (14), a second metal layer (16) and a coating layer (18) are sequentially stacked;
    forming (S20) a mounting groove (40) on the printed circuit board for mounting a light emitting device package (50); and
    mounting (S30) the light emitting device package (50) including a package body (51), a light emitting device (53) formed on the package body (51) and a lead (54) connected to the second metal layer (16) on the mounting groove (40),
    wherein the mounting groove (40) has a depth reaching at least an upper surface of the first metal layer (12).

11. The manufacturing method according to claim 10, wherein the first metal layer (12) is any one of an aluminum layer and a copper layer, and the second metal layer (16) is a copper layer.

**12.** The manufacturing method according to claim 10 or 11, wherein the light emitting device package (50) further comprises a heat sink (52) connected to the package body (51) to form a heat transfer route.

**13.** The manufacturing method according to any one of claims 10 to 12, wherein the mounting groove (40) has substantially the same width as that of the light emitting device package (50).

**14.** The manufacturing method according to any one of claims 10 to 13, wherein the first metal layer (12) has a thickness larger than that of the second metal layer (16).

**15.** The manufacturing method according to any one of claims 12 to 14, wherein the light emitting device package (50) further comprises a solder (30) coated between the heat sink (52) and the first metal layer (12).

**16.** The manufacturing method according to any one of claims 12 to 15, wherein the heat sink (52) is in contact with a lower side of the package body (51).

**17.** The manufacturing method according to any one of claims 10 to 16, wherein the lead (54) is connected to the second metal layer (16) by a solder (30) in the coating layer (18) positioned on the second metal layer (16).

**18.** The manufacturing method according to any one of claims 10 to 17, wherein the coating layer (18) is a solder resist.

**Patentansprüche**

**1.** Lichtemittierende Vorrichtung, die aufweist:

eine Leiterplatte (10), die aufweist:

eine erste Metallschicht (12);
eine auf der ersten Metallschicht angeordnete Isolierschicht (14);
eine auf der Isolierschicht angeordnete zweite Metallschicht (16);
eine auf der zweiten Metallschicht angeordnete Überzugsschicht (18); und
eine Montagenut (40) zum Montieren einer lichtemittierenden Bauelementeinheit (50); und

wobei die lichtemittierende Bauelementeinheit (50) aufweist:

einen Einheitenkörper (51);
ein auf dem Einheitenkörper ausgebildetes lichtemittierendes Bauelement (53); und
einen mit der zweiten Metallschicht verbundenen Draht (54),

wobei die Montagenut (40) eine Tiefe hat, die wenigstens eine obere Oberfläche der ersten Metallschicht (12) erreicht.

**2.** Lichtemittierende Vorrichtung nach Anspruch 1, wobei die erste Metallschicht (12) eine Aluminiumschicht oder eine Kupferschicht ist und die zweite Metallschicht (16) eine Kupferschicht ist.

**3.** Lichtemittierende Vorrichtung nach Anspruch 1 oder 2, wobei die lichtemittierende Bauelementeinheit (50) ferner eine mit dem Einheitenkörper (51) verbundene Wärmesenke (52) aufweist, um einen Wärmeübertragungsweg zu bilden.

**4.** Lichtemittierende Vorrichtung nach einem der Ansprüche 1 bis 3, wobei die Montagenut (40) im Wesentlichen die gleiche Breite wie die der lichtemittierenden Bauelementeinheit (50) hat.

**5.** Lichtemittierende Vorrichtung nach einem der Ansprüche 1 bis 4, wobei die erste Metallschicht (12) eine größere Dicke als die der zweiten Metallschicht (16) hat.

**6.** Lichtemittierende Vorrichtung nach einem der Ansprüche 3 bis 5, wobei die die lichtemittierende Bauelementeinheit (50) ferner ein Lot (30) aufweist, das zwischen der Wärmesenke (52) und der ersten Metallschicht (12) aufgetragen ist.

7. Lichtemittierende Vorrichtung nach einem der Ansprüche 3 bis 6, wobei die Wärmesenke (52) in Kontakt mit einer Unterseite des Einheitenkörpers (51) ist.

8. Lichtemittierende Vorrichtung nach einem der Ansprüche 1 bis 7, wobei der Draht (54) durch ein Lot (30) in der Überzugsschicht (18), die auf der zweiten Metallschicht (16) positioniert ist, mit der zweiten Metallschicht (16) verbunden ist.

9. Lichtemittierende Vorrichtung nach einem der Ansprüche 1 bis 8, wobei die Überzugsschicht (18) ein Lötstopplack ist.

10. Herstellungsverfahren für eine lichtemittierende Vorrichtung, das aufweist:

Anfertigen (S10) einer Leiterplatte (10), in der eine erste Metallschicht (12), eine Isolierschicht (14), eine zweite Metallschicht (16) und eine Überzugsschicht (18) nacheinander geschichtet werden;
Ausbilden (S20) einer Montagenut (40) auf der Leiterplatte zum Montieren einer lichtemittierenden Bauelementeinheit (50); und
Montieren (S30) der lichtemittierende Bauelementeinheit (50) mit einem Einheitenkörper (51), einem auf dem Einheitenkörper (51) ausgebildeten lichtemittierenden Bauelement (53) und einem mit der zweiten Metallschicht (16) verbundenen Draht (54) auf der Montagenut (40),
wobei die Montagenut (40) eine Tiefe hat, die wenigstens eine obere Oberfläche der ersten Metallschicht (12) erreicht.

11. Herstellungsverfahren nach Anspruch 10, wobei die erste Metallschicht (12) eine Aluminiumschicht oder eine Kupferschicht ist und die zweite Metallschicht (16) eine Kupferschicht ist.

12. Herstellungsverfahren nach Anspruch 10 oder 11, wobei die lichtemittierende Bauelementeinheit (50) ferner eine mit dem Einheitenkörper (51) verbundene Wärmesenke (52) aufweist, um einen Wärmeübertragungsweg zu bilden.

13. Herstellungsverfahren nach einem der Ansprüche 10 bis 12, wobei die Montagenut (40) im Wesentlichen die gleiche Breite wie die der lichtemittierenden Bauelementeinheit (50) hat.

14. Herstellungsverfahren nach einem der Ansprüche 10 bis 13, wobei die erste Metallschicht (12) eine größere Dicke als die der zweiten Metallschicht (16) hat.

15. Herstellungsverfahren nach einem der Ansprüche 12 bis 14, wobei die lichtemittierende Bauelementeinheit (50) ferner ein Lot (30) aufweist, das zwischen der Wärmesenke (52) und der ersten Metallschicht (12) aufgetragen ist.

16. Herstellungsverfahren nach einem der Ansprüche 12 bis 15, wobei die Wärmesenke (52) in Kontakt mit einer Unterseite des Einheitenkörpers (51) ist.

17. Herstellungsverfahren nach einem der Ansprüche 10 bis 16, wobei der Draht (54) durch ein Lot (30) in der Überzugsschicht (18), die auf der zweiten Metallschicht (16) positioniert ist, mit der zweiten Metallschicht (16) verbunden ist.

18. Herstellungsverfahren nach einem der Ansprüche 10 bis 17, wobei die Überzugsschicht (18) ein Lötstopplack ist.

**Revendications**

1. Appareil électroluminescent comprenant :

une carte à circuit imprimé (10) comprenant :

une première couche métallique (12) ;
une couche isolante (14) disposée sur la première couche métallique ;
une deuxième couche métallique (16) disposée sur la couche isolante ;
une couche de revêtement (18) disposée sur la deuxième couche métallique ;

et

une rainure de montage (40) pour monter un boîtier de dispositif électroluminescent (50) ; et

le boîtier de dispositif électroluminescent (50) comprenant :

un corps de boîtier (51) ;

un dispositif électroluminescent (53) formé sur le corps de boîtier ; et

un conducteur (54) relié à la deuxième couche métallique,

dans lequel la rainure de montage (40) a une profondeur atteignant au moins une surface supérieure de la première couche métallique (12).

2. Appareil électroluminescent selon la revendication 1, dans lequel la première couche métallique (12) est l'une quelconque parmi une couche d'aluminium et une couche de cuivre, et la deuxième couche métallique (16) est une couche de cuivre.

3. Appareil électroluminescent selon la revendication 1 ou 2, dans lequel le boîtier de dispositif électroluminescent (50) comprend en outre un dissipateur de chaleur (52) raccordé au corps de boîtier (51) afin de former une voie de transfert thermique.

4. Appareil électroluminescent selon l'une quelconque des revendications 1 à 3, dans lequel la rainure de montage (40) a sensiblement la même largeur que le boîtier de dispositif électroluminescent (50).

5. Appareil électroluminescent selon l'une quelconque des revendications 1 à 4, dans lequel la première couche métallique (12) a une épaisseur supérieure à celle de la deuxième couche métallique (16).

6. Appareil électroluminescent selon l'une quelconque des revendications 3 à 5, dans lequel le boîtier de dispositif électroluminescent (50) comprend en outre de la soudure (30) appliquée entre le dissipateur de chaleur (52) et la première couche métallique (12).

7. Appareil électroluminescent selon l'une quelconque des revendications 3 à 6, dans lequel le dissipateur de chaleur (52) est en contact avec un côté inférieur du corps de boîtier (51).

8. Appareil électroluminescent selon l'une quelconque des revendications 1 à 7, dans lequel le conducteur (54) est relié à la deuxième couche métallique (16) par de la soudure (30) dans la couche de revêtement (18) positionnée sur la deuxième couche métallique (16).

9. Appareil électroluminescent selon l'une quelconque des revendications 1 à 8, dans lequel la couche de revêtement (18) est un résist en soudure.

10. Procédé de fabrication d'un appareil électroluminescent, comprenant les étapes consistant à :

préparer (S10) une carte à circuit imprimé (10) dans laquelle une première couche métallique (12), une couche isolante (14), une deuxième couche métallique (16) et une couche de revêtement (18) sont empilées de manière séquentielle ;

former (S20) une rainure de montage (40) sur la carte à circuit imprimé pour monter un boîtier de dispositif électroluminescent (50) ; et

monter (S30) le boîtier de dispositif électroluminescent (50) comprenant un corps de boîtier (51), un dispositif électroluminescent (53) formé sur le corps de boîtier (51) et un conducteur (54) relié à la deuxième couche métallique (16) sur la rainure de montage (40),

dans lequel la rainure de montage (40) a une profondeur atteignant au moins une surface supérieure de la première couche métallique (12).

11. Procédé de fabrication selon la revendication 10, dans lequel la première couche métallique (12) est l'une quelconque parmi une couche d'aluminium et une couche de cuivre, la deuxième couche métallique (16) est une couche de cuivre.

12. Procédé de fabrication selon la revendication 10 ou 11, dans lequel le boîtier de dispositif électroluminescent (50) comprend en outre un dissipateur de chaleur (52) raccordé au corps de boîtier (51) afin de former une voie de transfert thermique.

13. Procédé de fabrication selon l'une quelconque des revendications 10 à 12, dans lequel la rainure de montage (40) a sensiblement la même largeur que le boîtier de dispositif électroluminescent (50).

**14.** Procédé de fabrication selon l'une quelconque des revendications 10 à 13, dans lequel la première couche métallique (12) a une épaisseur supérieure à celle de la deuxième couche métallique (16).

**15.** Procédé de fabrication selon l'une quelconque des revendications 12 à 14, dans lequel le boîtier de dispositif électroluminescent (50) comprend en outre de la soudure (30) appliquée entre le dissipateur de chaleur (52) et la première couche métallique (12).

**16.** Procédé de fabrication selon l'une quelconque des revendications 12 à 15, dans lequel le dissipateur de chaleur (52) est en contact avec un côté inférieur du corps de boîtier (51).

**17.** Procédé de fabrication selon l'une quelconque des revendications 10 à 16, dans lequel le conducteur (54) est relié à la deuxième couche métallique (16) par de la soudure (30) dans la couche de revêtement (18) positionnée sur la deuxième couche métallique (16).

**18.** Procédé de fabrication selon l'une quelconque des revendications 10 à 17, dans lequel la couche de revêtement (18) est un résist en soudure.

## FIG. 1

HEAT EMISSION ROUTE

## FIG. 2

# FIG. 3

HEAT EMISSION ROUTE          HEAT EMISSION ROUTE

# FIG. 4

```
        ┌─────────────┐
        │    START    │
        └──────┬──────┘
               │
               ▼
┌─────────────────────────────────┐
│ PREPARING PRINTED CIRCUIT BOARD │──S10
└────────────────┬────────────────┘
               │
               ▼
┌─────────────────────────────────┐
│     FORMING HOLE ON PRINTED      │
│         CIRCUIT BOARD            │──S20
└────────────────┬────────────────┘
               │
               ▼
┌─────────────────────────────────┐
│     MOUNTING LIGHT EMITTING      │
│        DEVICE PACKAGE            │──S30
└────────────────┬────────────────┘
               │
               ▼
        ┌─────────────┐
        │     END     │
        └─────────────┘
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2007002644 A